# EUROPEAN PATENT APPLICATION

(11) **EP 4 597 767 A1**
(43) Date of publication of application: **06.08.2025**
(21) Application number: 24211872.7
(22) Date of filing: 08.11.2024
(51) Int. Cl.: H02B 1/28, H02B 13/025, H05K 5/02

(54) **CASE AND ELECTRICAL EQUIPMENT**

(30) Priority: 05.02.2024 CN 202420280737 U
(71) Applicant: Sungrow Power Supply Co., Ltd., Hefei, Anhui 230088 (CN)
(72) Inventor: WANG, Hou, Hefei, 230088 (CN); CHEN, Lin, Hefei, 230088 (CN)
(74) Representative: Rooney, John-Paul

(57) **Abstract**

The present application relates to a case and electrical equipment. The case includes a case main body and a connecting assembly. The case main body has multiple connection regions that surround a center of the case main body and are spaced apart from each other, and the case main body includes a case body and a cover body. The connecting assembly includes multiple support members having at least three different structures, and the multiple support members are located in the multiple connection regions in one-to-one correspondence, and are connected between a bottom wall of the case body and the cover body. Strengths of the multiple support members having the at least three different structures decrease in sequence, and one of the multiple support members with a lowest strength has such a structure that a gap, which allows air to flow through, is formed when a pressure inside the case main body reaches a preset threshold. In this way, a multi-level pressure relief effect is realized, so that the pressure inside the case main body can be stably relieved, and the cover body is less likely to be blasted away, thereby reducing the safety hazards of the case.

## Description

### FIELD

The present application relates to the technical field of cases, and in particular to a case and electrical equipment.

### BACKGROUND

A case of conventional electrical equipment generally includes a case body, a cover plate and a long stud with an explosion-proof sleeve. The case body and the cover plate are connected through the long stud, so that the explosion-proof sleeve deforms to relieve pressure when the case of the conventional electrical equipment explodes. However, the case of the conventional electrical equipment has a relatively high safety hazard.

### SUMMARY

Based on this, a case and electrical equipment are expected to be provided to solve the problem of a high safety hazard in conventional electrical equipment.

In a first aspect of the present application, a case is provided, including a case main body and a connecting assembly,
the case main body has multiple connection regions that surround a center of the case main body and are spaced apart from each other, and the case main body includes an case body and a cover body;
the connecting assembly includes multiple support members having at least three different structures, and the multiple support members are located in the multiple connection regions in one-to-one correspondence, and are connected between a bottom wall of the case body and the cover body; and
strengths of the multiple support members having the at least three different structures decrease in sequence, and one of the multiple support members with a lowest strength has such a structure that a gap, which allows air to flow through, is formed when a pressure inside the case main body reaches a preset threshold.

In an embodiment, the multiple connection regions include a reinforcement connection region, a transition connection region and a weak connection region;
the multiple support members include a reinforcement support member located in the reinforcement connection region, a transition support member located in the transition connection region, and a weak support member located in the weak connection region;
a strength of the reinforcement support member, a strength of the transition support member, and a strength of the weak support member decrease in a listed sequence; and
the weak support member has such a structure that the gap, which allows the air to flow through, is formed when the pressure inside the case main body reaches the preset threshold.

In an embodiment, the case body and the cover body are arranged towards each other along a first direction;
the reinforcement support member includes a reinforcement portion, and the reinforcement portion is connected along the first direction to a side of the bottom wall of the case body close to the cover body;
the weak support member includes a weak portion, the weak portion is connected along the first direction to the side of the bottom wall of the case body close to the cover body, and the weak portion has such a structure that the gap, which allows the air to flow through, is formed when the pressure inside the case main body reaches the preset threshold; and
a size of the reinforcement portion along the first direction is larger than a size of the weak portion along the first direction.

In an embodiment, the size of the reinforcement portion along the first direction is D1, the size of the weak portion along the first direction is D2, and D1 > 2*D2.

In an embodiment, the reinforcement support member further includes a first connecting portion, and the first connecting portion is connected to a side of the reinforcement portion away from the bottom wall of the case body along the first direction; and
the first connecting portion is detachably connected to the cover body.

In an embodiment, the connecting assembly further includes a first gasket and a first cover body connector, and the first cover body connector passes through the first gasket, the cover body and the first connecting portion along the first direction, so that the first gasket, the cover body and the first connecting portion are detachably connected.

In an embodiment, the weak support member further includes a second connecting portion, and the second connecting portion is connected to a side of the weak portion away from the bottom wall of the case body along the first direction; and
the second connecting portion is detachably connected to the cover body.

In an embodiment, the connecting assembly further includes a second gasket and a second cover body connector, and the second cover body connector passes through the second gasket, the cover body and the second connecting portion along the first direction, so that the second gasket, the cover body and the second connecting portion are detachably connected.

In an embodiment, the connecting assembly further includes an explosion-proof reinforcement member, a reinforcement connector and a reinforcement fastener; and
the reinforcement connector passes through the explosion-proof reinforcement member, the bottom wall of the case body and the reinforcement portion in a listed sequence along the first direction, and an end of the reinforcement connector passing out of the reinforcement portion along the first direction is detachably connected to the reinforcement fastener.

In an embodiment, the connecting assembly further includes a weak connector and a weak fastener; and
the weak connector passes through the bottom wall of the case body and the weak portion in sequence along the first direction, and an end of the weak connector passing out of the weak portion along the first direction is detachably connected to the weak fastener.

In an embodiment, the weak portion is provided with a groove and/or a notch, so that the gap, which allows the air to flow through, is formed at the weak portion when the pressure inside the case main body reaches the preset threshold.

In an embodiment, the case main body further includes the transition connection region, and the reinforcement connection region, the weak connection region and the transition connection region surround the center of the case main body and are spaced apart from each other;
the connecting assembly further includes the transition support member located in the transition connection region;
the transition support member is connected between the bottom wall of the case body and the cover body; and
the strength of the reinforcement support member is larger than the strength of the transition support member, and the strength of the transition support member is larger than the strength of the weak support member.

In a second aspect of the present application, electrical equipment is provided, including the case according to any one of the above embodiments.

According to the technical solutions of the present application, a connection performance between the case body and the cover body is enhanced by the support member with the highest strength, so that the cover body can hardly be separated from the case body, and therefore is less likely to be blasted away.

### BRIEF DESCRIPTION OF THE DRAWINGS

FIG. 1 is a schematic view showing the structure of electrical equipment according to an embodiment of the present application;
FIG. 2 is a schematic sectional view of FIG. 1 along a line A-A;
FIG. 3 is a first schematic sectional view of a reinforcement connection region of an case according to an embodiment of the present application;
FIG. 4 is a second schematic sectional view of a weak connection region of the case according to an embodiment of the present application;
FIG. 5 is a third schematic sectional view of the reinforcement connection region of the case according to an embodiment of the present application;
FIG. 6 is a fourth schematic sectional view of the weak connection region of the case according to an embodiment of the present application;
FIG. 7 is a fifth schematic sectional view of a transition connection region of the case according to an embodiment of the present application; and
FIG. 8 is a sixth schematic sectional view of the transition connection region of the case according to an embodiment of the present application.

**Reference numerals:**

| | | | |
|---|---|---|---|
| 1 | electrical equipment, | 10 | case, |
| 100 | case main body, | 101 | reinforcement connection region, |
| 102 | weak connection region, | 103 | transition connection region, |
| 110 | case body, | 111 | bottom wall, |
| 120 | cover body, | 200 | connecting assembly, |
| 210 | reinforcement support member, | 211 | reinforcement portion, |
| 212 | first connecting portion, | 213 | reinforcement demolding groove, |
| 220 | weak support member, | 221 | weak portion, |
| 2211 | notch, | 222 | second connecting portion, |
| 223 | weak demolding groove, | 231 | first gasket, |
| 232 | second gasket, | 233 | third gasket, |
| 241 | first cover body connector, | 242 | second cover body connector, |
| 243 | third cover body connector, | | |
| 250 | explosion-proof reinforcement member, | | |
| 261 | reinforcement connector, | 262 | weak connector, |
| 263 | transition connector, | 271 | reinforcement fastener, |
| 272 | weak fastener, | 273 | transition fastener, |
| 280 | transition support member, | 281 | transition portion, |
| 282 | third connecting portion, | 283 | transition demolding groove. |

### DETAILED DESCRIPTION OF THE EMBODIMENTS

Specific embodiments of the present application will be described clearly and completely as follows in conjunction with the accompany drawings, so that purposes, characteristics and advantages of the present application can be more obvious and understandable. A lot of specific details are described in the following description to help to comprehensively understand the present application. The present application may be implemented in other ways different from what is described herein. Similar modifications may be made by those skilled in the art without violating the concept of the present application, and therefore the present application is not limited by the specific embodiments disclosed hereinafter.

In the description of the present application, it should be understood that, if there are terms such as "center", "longitudinal", "transverse", "length", "width", "thickness", "up", "down", "front", "rear", "left", "right", "vertical", "horizontal", "top", "bottom", "inner", "outer", "clockwise", "counter-clockwise", "axial direction", "radial direction", "circumferential direction" and the like, the orientation or positional relationships indicated by these terms are based on the orientation or positional relationships shown in the drawings, and are merely for the convenience of description of the present application and the simplification of the description, and do not indicate or imply that the device or element referred to must have a particular orientation, or be configured and operated in a particular orientation, which therefore should not be construed as a limitation to the scope of the present application.

In addition, if there are terms such as "first", "second" and the like, these terms are merely for description, and should not be construed as indicating or implying relative importance, or implicitly indicating the number of technical features being referred to. In this way, the feature defined by the terms "first", "second" may explicitly or implicitly include at least one such features. In the description of the present application, if there are terms such as "multiple", the "multiple" means at least two, such as two, three or the like, unless otherwise clearly and specifically defined.

In the description of the present application, unless otherwise clearly specified or limited, if there are terms such as "mounted to", "connected with", "connected to", and "fixed to", these terms should be construed broadly. For example, the connection may be in a fixed manner, a detachable manner, or an integral manner. The connection may be a mechanical connection or an electrical connection. The connection may be direct or indirect through an intermediate medium, or may be communication of interiors of two elements or an interaction between two elements, unless otherwise clearly and specifically defined. For those skilled in the art, the specific meanings of the above terms in the present application may be construed according to practice.

In the present application, unless otherwise clearly specified or limited, a first feature is "on top of" or "under" a second feature or similar descriptions may indicate the first feature and the second feature directly contact each other, or indirectly contact each other through an intermediate medium. Furthermore, the first feature is "on top of", "above", or "on" the second feature may indicate the first feature is exactly on top of the second feature or above the second feature in a staggered manner, or may only indicate the first feature is higher than the second feature. The first feature is "under", "below", or "at the bottom of" the second feature may indicate the first feature is exactly under the second feature or below the second feature in a staggered manner, or may only indicate the first feature is lower than the second feature.

It should be noted that, if a component is said to be "fixed to" or "provided on" another component, it may be directly on the another component or there may be an intermediate component. If a component is said to be "connected to" another component, it may be directly connected to the another component or there may be an intermediate component. Terms such as "vertical", "horizontal", "up", "down", "left", "right" and the like used in the present application are merely for description, and do not indicate the only implementation.

It is found through researches that a cover plate of conventional electrical equipment may be easily blasted away when an case of the electrical equipment explodes, bringing lots of safety hazards to the case of the conventional electrical equipment.

To solve the problem of the lots of safety hazards of the case of the conventional electrical equipment, an case is provided in the present application, so as to achieve multi-level pressure relief and make the cover body less likely to be blasted away, thereby reducing the safety hazards of the case.

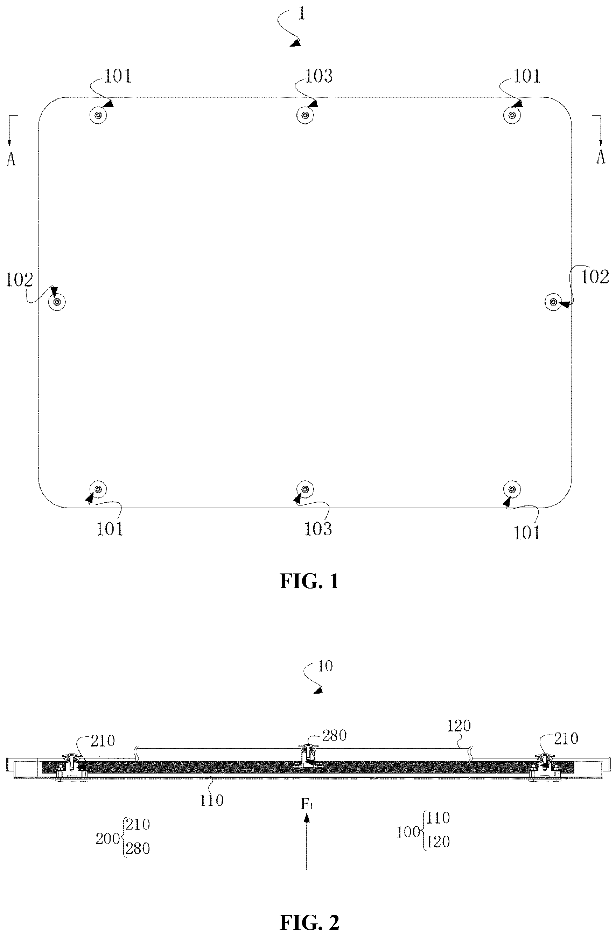

FIG. 1 is a schematic view showing the structure of electrical equipment 1 according to an embodiment of the present application, and FIG. 2 is a schematic sectional view of FIG. 1 along a line A-A.

Referring to FIGS. 1 and 2, the electrical equipment 1 includes a case 10 and electrical components. The electrical components are arranged inside the case 10 and are protected by the case 10.

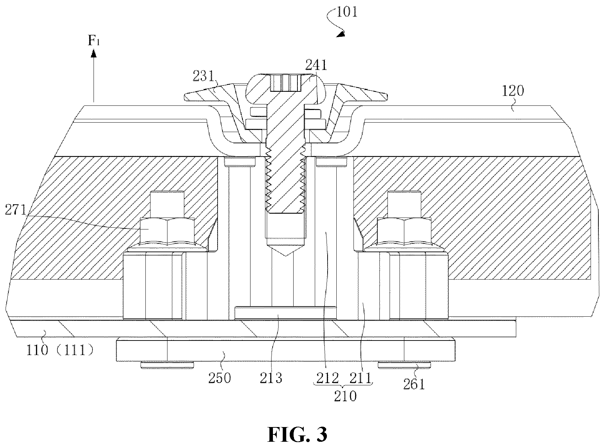

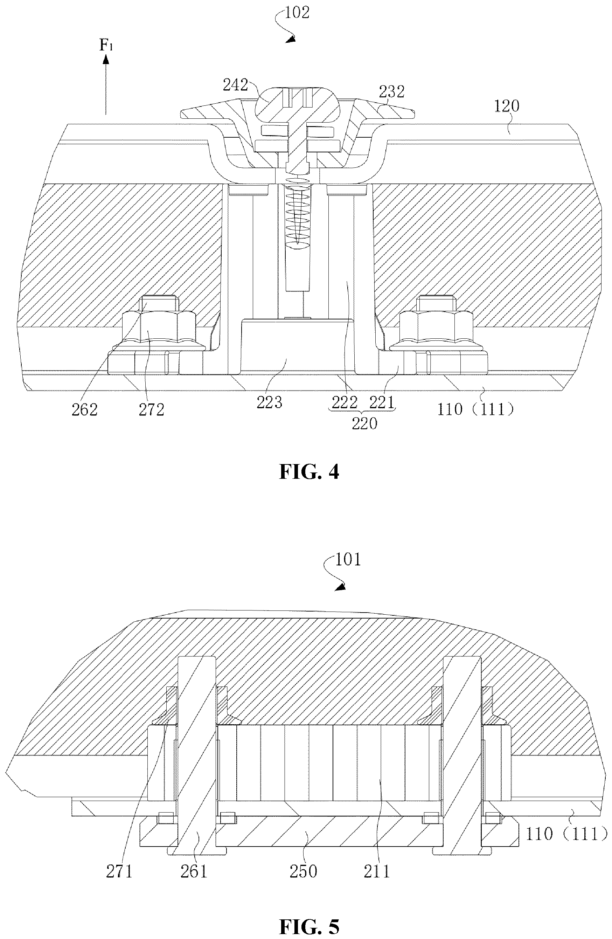

Referring to FIG. 1, and referring to FIGS. 3 and 4, the case 10 according to an embodiment of the present application includes a case main body 100 and a connecting assembly 200.

The case main body 100 has multiple connection regions that surround a center of the case main body 100 and are spaced apart from each other, and the case main body 100 includes a case body 110 and a cover body 120. The connecting assembly 200 includes multiple support members having at least three different structures, and the multiple support members are located in the multiple connection regions in one-to-one correspondence, and are connected between a bottom wall 111 of the case body 110 and the cover body 120. Strengths of the multiple support members having the at least three different structures decrease in sequence, and one of the multiple support members with a lowest strength has such a structure that a gap, which allows air to flow through, is formed when a pressure inside the case main body 100 reaches a preset threshold.

The description "the strengths of the multiple support members having the at least three different structures decrease in sequence" may refer to a case that the connecting assembly 200 includes multiple support members having three different structures, and strengths of the multiple support members having the three different structures decrease in sequence, or refer to another case that the connecting assembly 200 includes multiple support members having four different structures, and strengths of the multiple support members having the four different structures decrease in sequence, or the like.

In one aspect, a connection performance between the case body 110 and the cover body 120 is enhanced by the support member with the highest strength, so that the cover body 120 can hardly be separated from the case body 110, and therefore is less likely to be blasted away. In the other aspect, the gap, which allows the air to flow through, is formed at the support member with the lowest strength when the pressure inside the case main body 100 reaches the preset threshold, so that a part of the cover body 120 at the support member with the lowest strength can deform towards a side away from the case body 110 to form a pressure relief region, so that the pressure inside the case main body 100 is relieved from the connection region where the support member with relatively high strength is located to the connection region where the support member with the lowest strength is located. Since the multiple support members have at least three structures, and the strengths of the multiple support members having at least three structures decrease in sequence, a multi-level pressure relief effect can be achieved with the connecting assembly 200, so that the pressure inside the case main body 100 can be stably relieved, thereby realizing a relatively good explosion-proof performance. Moreover, the cover body 120 is less likely to be blasted away, and therefore the safety hazards of the case 10 are reduced.

In some embodiments, the multiple connection regions include a reinforcement connection region 101, a weak connection region 102 and a transition connection region 103. The multiple support members include a reinforcement support member 210 located in the reinforcement connection region 101, a weak support member 220 located in the weak connection region 102, and a transition support member 280 located in the transition connection region 103. A strength of the reinforcement support member 210, a strength of the transition support member 280, and a strength of the weak support member 220 decrease in a listed sequence. The weak support member 220 has such a structure that the gap, which allows the air to flow through, is formed at the weak support member when the pressure inside the case main body 100 reaches the preset threshold.

It may be appreciated that, the reinforcement support member 210, the weak support member 220 and the transition support member 280 are each connected between the bottom wall 111 of the case body 110 and the cover body 120.

In an embodiment, the case main body 100 has multiple reinforcement connection regions 101 that surround the center of the case main body 100 and are spaced apart from each other. One weak connection region 102 or one transition connection region 103 is provided between each two adjacent reinforcement connection regions 101. In an example, the case main body 100 has four reinforcement connection regions 101 that surround the center of the case main body 100 and are spaced apart from each other. One weak connection region 102 is provided between a first reinforcement connection region 101 and a second reinforcement connection region 101, and one transition connection region 103 is provided between the second reinforcement connection region 101 and a third reinforcement connection region 103. Another weak connection region 102 is provided between the third reinforcement connection region 101 and a fourth reinforcement connection region 101, and another transition connection region 103 is provided between the first reinforcement connection region 101 and the fourth reinforcement connection region 101. Certainly, the present application is not limited to this example, as long as all of the reinforcement connection regions 101, all of the weak connection regions 102, and all of the transition connection regions 103 surround the center of the case main body 100 and are spaced apart from each other.

The reinforcement support member 210 is connected between the bottom wall 111 of the case body 110 and the cover body 120, and the weak support member 220 is connected between the bottom wall 111 of the case body 110 and the cover body 120. The strength of the reinforcement support member 210 is higher than the strength of the weak support member 220.

The weak support member 220 refers to a support member that has the smallest strength compared with the reinforcement support member 210 and the transition support member 280, and has such a structure that the gap, which allows the air to flow through, is formed when the pressure inside the case main body 100 reaches the preset threshold.

The reinforcement support member 210 refers to a support member that has the largest strength compared with the weak support member 220 and the transition support member 280, and can enhance the connection performance between the case body 110 and the cover body 120.

The transition support member 280 refers to a support member with a strength between the strength of the weak support member 220 and the strength of the reinforcement support member 210.

In one aspect, the connection performance between the case body 110 and the cover body 120 is improved with the reinforcement support member 210. In the other aspect, the strength of the reinforcement support member 210, the strength of the transition support member 280, and the strength of the weak support member 220 decrease in a listed sequence. Therefore, when the pressure inside the case main body 100 reaches the preset threshold, the gap, which allows the air to flow through, is more likely to form on the weak support member 220 than on the transition support member 280. In this way, the weak support member 102 serves as a first-level pressure relief region, and the transition support member 103 serves as a second-level pressure relief region, so that the pressure inside the case main body 100 can be stably relieved. As the cover body 120 can hardly be separated from the case body 110, the cover body 120 may swell up at a center, thereby achieving a relatively good explosion-proof performance.

In an embodiment, the weak connection region 102 is located further out than the reinforcement connection region 101 along a direction parallel to a direction from the center of the case main body 100 to an outer peripheral edge of the case main body 100.

In this way, when the pressure inside the case main body 100 reaches the preset threshold, the pressure can be relieved from the inner reinforcement connection region 101 to the outer weak connection region 102, making the cover body 120 swell up at the center, so that the pressure is relieved, and the cover body 120 is less likely to be blasted away, and therefore the safety hazards of the case 10 are reduced.

In an embodiment, the reinforcement connection region 101 and the weak connection region 102 are arranged adjacent to each other along a circumferential direction of the case main body 100.

In this way, when the pressure inside the case main body 100 reaches the preset threshold, the pressure inside the case main body 100 can be quickly relieved from the reinforcement connection region 101 to the weak connection region 102, so that the pressure is quickly relieved, and the cover body 120 is less likely to be blasted away, thereby reducing the safety hazards of the case 10.

In some embodiments, referring to FIGS. 3 to 6, the case body 110 and the cover body 120 are arranged towards each other along a first direction F₁. The reinforcement support member 210 includes a reinforcement portion 211, and the reinforcement portion 211 is connected along the first direction F₁ to a side of the bottom wall 111 of the case body 110 close to the cover body 120. The weak support member 220 includes a weak portion 221. The weak portion 221 is connected along the first direction F₁ to the side of the bottom wall 111 of the case body 110 close to the cover body 120, and the weak portion 221 has such a structure that the gap, which allows the air to flow through, is formed when the pressure inside the case main body 100 reaches the preset threshold. Along the first direction F₁, a size of the reinforcement portion 211 is larger than a size of the weak portion 221.

It may be appreciated that, the size of the reinforcement portion 211 along the first direction F₁ is a thickness of the reinforcement portion 211, and the size of the weak portion 221 along the first direction F₁ is a thickness of the weak portion 221.

In this way, the connection performance between the case body 110 and the cover body 120 is enhanced with the thicker reinforcement portion 211, so that the cover body 120 can hardly be separated from the case body 110, and therefore is less likely to be blasted away. Moreover, with the thinner weak portion 221, the gap, which allows the air to pass through, can be more easily formed on the weak support member 220 when the pressure inside the case main body 100 reaches the preset threshold, to form a pressure relief region at the weak portion 102 to relieve the pressure, so that the pressure is relieved, and the cover body 120 is less likely to be blasted away, thereby reducing the safety hazards of the case 10.

In some embodiments, the size of the reinforcement portion 221 along the first direction is D1, the size of the weak portion 221 along the first direction is D2, and D1 > 2*D2.

That is to say, the thickness of the reinforcement portion 211 is much larger than the thickness of the weak portion 221. In this way, the connection performance between the case body 110 and the cover body 120 can be better improved, and the gap, which allows the air to pass through, can be more easily formed on the weak support member 220 when the pressure inside the case main body 100 reaches the preset threshold, so that the pressure is better relieved, and the cover body 120 is less likely to be blasted away, thereby reducing the safety hazards of the case 10.

In some embodiments, referring to FIG. 3, the reinforcement support member 210 further includes a first connecting portion 212. The first connecting portion 212 is connected to a side of the reinforcement portion 211 away from the bottom wall 111 of the case body 110 along the first direction F₁, and the first connecting portion 212 is detachably connected to the cover body 120.

The first connecting portion 212 is detachably connected to the cover body 120, which facilitates mounting and dismounting of the case body 110 and the cover body 120 of the case 10. The connection performance between the cover body 120 and the reinforcement support member 210 can also be improved, and therefore the cover body 120 is less likely to be blasted away, thereby reducing the safety hazards of the case 10.

In the present embodiment, referring to FIG. 3, the connecting assembly 200 further includes a first gasket 231 and a first cover body connector 241, and the first cover body connector 241 passes through the first gasket 231, the cover body 120 and the first connecting portion 212 along the first direction F₁, so that the first gasket 231, the cover body 120 and the first connecting portion 212 are detachably connected.

Specifically, the first cover body connector 241 is a first screw. The first gasket 231 and the cover body 120 are each provided with a first through hole for the first screw to pass through, and the first connecting portion 212 is provided with a first threaded hole that matches the first screw.

In this way, the first gasket 231, the cover body 120 and the first connecting portion 212 can be detachably connected, so that the reinforcement portion 211 of the reinforcement support member 210 is connected along the first direction F₁ to the side of the bottom wall 111 of the case body 110 close to the cover body 120, and the first connecting portion 212 of the reinforcement support member 210 is detachably connected to the cover body 120 along the first direction F₁. With such arrangement and with the first gasket 231, the connection performance between the cover body 120 and the reinforcement support member 210 can be improved, so that the cover body 120 can be better prevented from being blasted away, thereby reducing the safety hazards of the case 10.

In some embodiments, referring to FIG. 4, the weak support member 220 further includes a second connecting portion 222. The second connecting portion 222 is connected to a side of the weak portion 221 away from the bottom wall 111 of the case body 110 along the first direction F₁, and the second connecting portion 222 is detachably connected to the cover body 120.

The second connecting portion 222 is detachably connected to the cover body 120, which facilitates mounting and dismounting of the case body 110 and the cover body 120 of the case 10. The connection performance between the cover body 120 and the weak support member 220 can also be improved, and therefore the cover body 120 is less likely to be blasted away, thereby reducing the safety hazards of the case 10.

In the present embodiment, the connecting assembly 200 further includes a second gasket 232 and a second cover body connector 242, and the second cover body connector 242 passes through the second gasket 232, the cover body 120 and the second connecting portion 222 along the first direction F₁, so that the second gasket 232, the cover body 120 and the second connecting portion 222 are detachably connected.

Specifically, the second cover body connector 242 is a second screw. The second gasket 232 and the cover body 120 are each provided with a second through hole for the second screw to pass through, and the second connecting portion 222 is provided with a second threaded hole that matches the second screw.

In this way, the second gasket 232, the cover body 120 and the second connecting portion 222 can be detachably connected, so that the weak portion 221 of the weak support member 220 is connected along the first direction F₁ to the side of the bottom wall 111 of the case body 110 close to the cover body 120, and the second connecting portion 222 of the weak support member 220 is detachably connected to the cover body 120 along the first direction F₁. With such arrangement and with the second gasket 232, the connection performance between the cover body 120 and the weak support member 220 can be improved, so that the cover body 120 can be better prevented from being blasted away, thereby reducing the safety hazards of the case 10.

In some embodiments, referring to FIGS. 3 and 5, the connecting assembly 200 further includes an explosion-proof reinforcement member 250, a reinforcement connector 261 and a reinforcement fastener 271. The reinforcement connector 261 passes through the explosion-proof reinforcement member 250, the bottom wall 111 of the case body 110 and the reinforcement portion 211 in a listed sequence along the first direction F₁, and an end of the reinforcement connector 261 passing out of the reinforcement portion 211 along the first direction F₁ is detachably connected to the reinforcement fastener 271.

Specifically, the reinforcement connector 261 is a reinforcement screw, and the reinforcement fastener 271 is a fastening nut that matches the reinforcement screw.

It may be appreciated that, the reinforcement portion 211, the bottom wall 111 of the case body 110 and the explosion-proof reinforcement member 250 are arranged in stack along the first direction F₁, so that the reinforcement connector 261 passes through the explosion-proof reinforcement member 250, the bottom wall 111 of the case body 110 and the reinforcement portion 211 in a listed sequence along the first direction F₁, and the end of the reinforcement connector 261 passing out of the reinforcement portion 211 along the first direction F₁ is detachably connected to the reinforcement fastener 271. In this way, the connection performance between the case body 110 and the reinforcement support member 210 is enhanced with the explosion-proof reinforcement member 250 and the reinforcement connector 261. Therefore, the connection performance between the case body 110 and the cover body 120 can be improved when the reinforcement support member 210 is connected to the cover body 120, so that the cover body 120 can be better prevented from being blasted away, thereby reducing the safety hazards of the case 10.

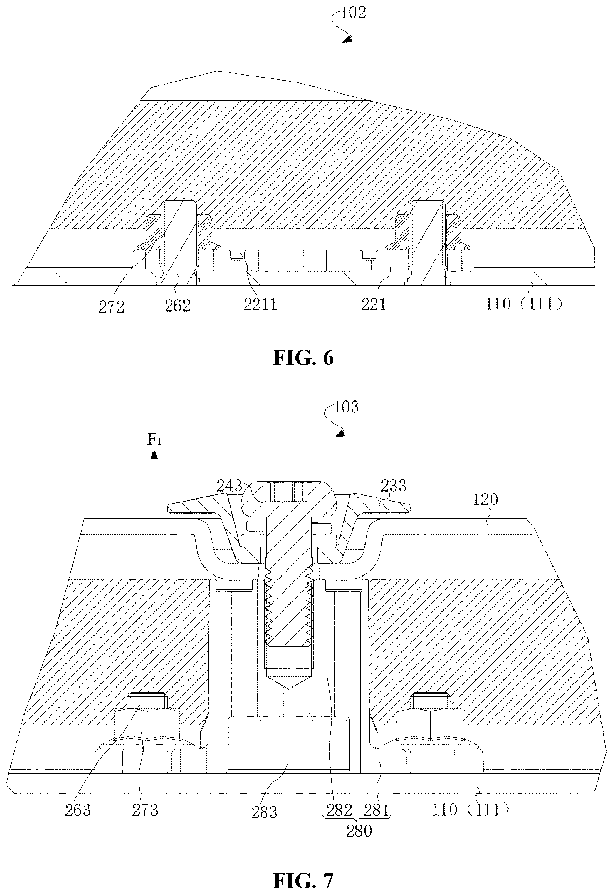

In some embodiments, referring to FIGS. 4 and 6, the connecting assembly 200 further includes a weak connector 262 and a weak fastener 272. The weak connector 262 passes through the bottom wall 111 of the case body 110 and weak portion 221 in sequence along the first direction F₁, and an end of the weak connector 262 passing out of the weak portion 221 along the first direction F₁ is detachably connected to the weak fastener 272.

Specifically, the weak connector 262 is a pressure rivet screw, and the weak fastener 272 is another fastening nut that matches the pressure rivet screw.

A length of the weak connector 262 is shorter than a length of the reinforcement connector 261, so that a strength of the weak connector 262 is lower than a strength of the reinforcement connector 261.

It may be appreciated that, the reinforcement connector 261 has a better connection performance than the weak connector 262, which is beneficial to the improvement of the connection performance between the case body 110 and the cover body 120 with the reinforcement support member 210, and the gap, which allows the air to pass through, can be better formed on the weak support member 220 when the pressure inside the case main body 100 reaches the preset threshold, so that the pressure is relieved, and the cover body 120 is less likely to be blasted away, thereby reducing the safety hazards of the case 10.

In some embodiments, referring to FIG. 6, the weak portion 221 is provided with a groove and/or a notch 2211, so that the gap, which allows the air to flow through, is formed at the weak portion 221 when the pressure inside the case main body 100 reaches the preset threshold.

The weak portion 221 may be provided with a groove, or may be provided with a notch 2211. Certainly, the weak portion 221 may be provided with both the groove and the notch 2211.

In an example, the weak portion 221 is provided with at least two notches 2211, and the at least two notches 2211 surround the second connecting portion 222.

In this way, when the pressure inside the case main body 100 reaches the preset threshold, the gap, which allows the air to flow through, can be formed at the at least two notches 2211 of the weak portion 221, so that a part of the cover body 120 in the weak connection region 102 deforms towards a side away from the case body 110 to form the pressure relief region to relieve the pressure. Moreover, the reinforcement support member 210 enhances the connection performance between the case body 110 and the cover body 120, and therefore the cover body 120 can hardly be separated from the case body 110, so that the cover body 120 is less likely to be blasted away, thereby reducing the safety hazards of the case 10.

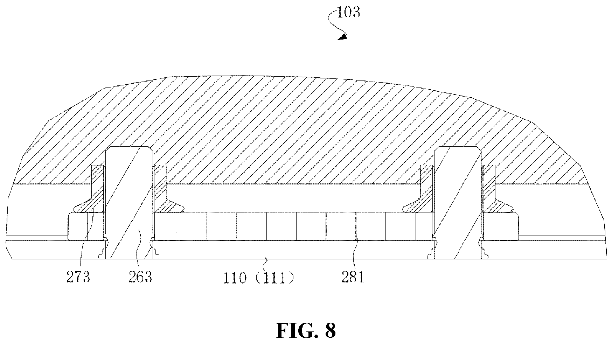

In some embodiments, referring to FIG. 1, and referring to FIGS. 7 and 8, the transition support member 280 includes a transition portion 281, and the transition portion 281 is connected along the first direction F₁ to the side of the bottom wall 111 of the case body 110 close to the cover body 120.

In an embodiment, the thickness of the reinforcement portion 221 is larger than a thickness of the transition portion 281, and the thickness of the transition portion 281 is larger than the thickness of the weak portion 221. The weak portion 221 is provided with the groove and/or the notch 2211, so that the gap, which allows the air to flow through, is formed at the weak portion 221 when the pressure inside the case main body 100 reaches the preset threshold. In this way, when the pressure inside the case main body 100 reaches the preset threshold, the gap, which allows the air to flow through, is more likely to form on the weak support member 220 than on the transition support member 280. In this way, the weak support member 102 serves as the first-level pressure relief region, and the transition support member 103 serves as the second-level pressure relief region, so that the pressure inside the case main body 100 can be stably relieved. As the cover body 120 can hardly be separated from the case body 110, the cover body 120 may swell up at the center, thereby achieving a relatively good explosion-proof performance.

In an embodiment, a reinforcement demolding groove 213 is provided at a side of the reinforcement support member 210 close to the bottom wall 111 of the case body 110 to facilitate demolding of the reinforcement support member 210.

In an embodiment, a weak demolding groove 223 is provided at a side of the weak support member 220 close to the bottom wall 111 of the case body 110 to facilitate demolding of the weak support member 220.

In an embodiment, a transition demolding groove 283 is provided at a side of the transition support member 280 close to the bottom wall 111 of the case body 110 to facilitate demolding of the transition support member 280.

Specifically, the connecting assembly 200 further includes a transition connector 263 and a transition fastener 273. The transition connector 263 passes through the bottom wall 111 of the case body 110 and the transition portion 281 in sequence along the first direction F₁, and an end of the transition connector 263 passing out of the transition portion 281 along the first direction F₁ is detachably connected to the transition fastener 273.

Specifically, the transition connector 263 is a transition screw, and the transition fastener 273 is yet another fastening nut that matches the transition screw.

It may be appreciated that, the transition connector 263 passes through the bottom wall 111 of the case body 110 and the transition portion 281 in sequence along the first direction F₁, and the end of the transition connector 263 passing out of the transition portion 281 along the first direction F₁ is detachably connected to the transition fastener 273. In this way, the connection performance between the case body 110 and the transition support member 280 is enhanced with the transition connector 263 and the transition fastener 273. Therefore, the connection performance between the case body 110 and the cover body 120 can be improved when the transition support member 280 is connected to the cover body 120, so that the cover body 120 can be better prevented from being blasted away, thereby reducing the safety hazards of the case 10.

In the present embodiment, the transition support member 280 further includes a third connecting portion 282. The third connecting portion 282 is connected to a side of the transition portion 281 away from the bottom wall 111 of the case body 110 along the first direction F₁, and the third connecting portion 282 is detachably connected to the cover body 120.

In the present embodiment, the connecting assembly 200 further includes a third gasket 233 and a third cover body connector 243, and the third cover body connector 243 passes through the third gasket 233, the cover body 120 and the third connecting portion 282 along the first direction F₁, so that the third gasket 233, the cover body 120 and the third connecting portion 282 are detachably connected.

Specifically, the third cover body connector 243 is a third screw. The third gasket 233 and the cover body 120 are each provided with a third through hole for the third screw to pass through, and the third connecting portion 282 is provided with a third threaded hole that matches the third screw.

In this way, the third gasket 233, the cover body 120 and the third connecting portion 282 can be detachably connected, so that the transition portion 281 of the transition support member 280 is connected along the first direction F₁ to the side of the bottom wall 111 of the case body 110 close to the cover body 120, and the third connecting portion 282 of the transition support member 280 is detachably connected to the cover body 120 along the first direction F₁. With such arrangement and with the third gasket 233, the connection performance between the cover body 120 and the transition support member 280 can be improved, so that the cover body 120 can be better prevented from being blasted away, thereby reducing the safety hazards of the case 10.

Electrical equipment 1 is further provided in the present application, including the case 10 according to any one of the above embodiments.

In use of the case 10, when an explosion occurs inside the electrical equipment 1, the pressure inside the case main body 100 reaches the preset threshold, and the gap which allows the air to flow through can be formed at the notch 2211 of the weak portion 221, so that the part of the cover body 120 in the weak connection region 102 deforms towards the side away from the case body 110 to form the first-level pressure relief region to preliminarily relieve the pressure. When the transition connector 263 in the transition connection region 103 is pulled off, while the third connecting portion 282 of the transition support member 280 is still connected to the cover body 120, a part of the cover body 120 in the transition connection region 103 deforms towards the side away from the case body 110 to form the second-level pressure relief region to further relieve the pressure. At the same time, the connection performance between the case body 110 and the cover body 120 is enhanced by the reinforcement support member 210 located in the reinforcement connection region 101, so that the cover body 120 can hardly be separated from the case body 110. The case body 110 can also deform to absorb the energy, thereby forming a third-level explosion-proof pressure relief structure. Therefore, the case 10 swell up at the center when the explosion occurs inside the case 10, so that a relatively good explosion-proof performance is achieved, and the cover body 120 is less likely to be blasted away, thereby reducing the safety hazards of the case 10.

The technical features described in the above embodiments can be combined in any way. For clear description, not all possible combinations of the technical features in the above embodiments are described. However, all of these combinations of the technical features fall within the scope of this specification as long as they do not contradict each other.

Only a few of implementations of the present application are described in the above embodiments. The description thereof is relatively specific and detailed, but should not be construed as a limitation to the scope of the present application. It should be noted that, for those skilled in the art, a few of variations and improvements may be made without departing from the concepts of the present application, and all these variations and improvements are deemed to fall into the protection scope of the present application. Therefore, the protection scope of the present application is defined by the claims being attached.

## Claims

1. A case, comprising an case main body and a connecting assembly, wherein
the case main body has a plurality of connection regions that surround a center of the case main body and are spaced apart from each other, and the case main body comprises an case body and a cover body;
the connecting assembly comprises a plurality of support members having at least three different structures, and the plurality of support members are located in the plurality of connection regions in one-to-one correspondence, and are connected between a bottom wall of the case body and the cover body; and
strengths of the plurality of support members having the at least three different structures decrease in sequence, and one of the plurality of support members with a lowest strength has such a structure that a gap, which allows air to flow through, is formed with the lowest strength when a pressure inside the case main body reaches a preset threshold.

2. The case according to claim 1, wherein
the plurality of connection regions comprise a reinforcement connection region, a transition connection region and a weak connection region;
the plurality of support members comprise a reinforcement support member located in the reinforcement connection region, a transition support member located in the transition connection region, and a weak support member located in the weak connection region;
a strength of the reinforcement support member, a strength of the transition support member, and a strength of the weak support member decrease in a listed sequence; and
the weak support member has such a structure that the gap, which allows the air to flow through, is formed when the pressure inside the case main body reaches the preset threshold.

3. The case according to claim 2, wherein
the case body and the cover body are arranged towards each other along a first direction;
the reinforcement support member comprises a reinforcement portion, and the reinforcement portion is connected along the first direction to a side of the bottom wall of the case body close to the cover body;
the weak support member comprises a weak portion, the weak portion is connected along the first direction to the side of the bottom wall of the case body close to the cover body, and the weak portion has such a structure that the gap, which allows the air to flow through, is formed when the pressure inside the case main body reaches the preset threshold; and
a size of the reinforcement portion along the first direction is larger than a size of the weak portion along the first direction.

4. The case according to claim 3, wherein the size of the reinforcement portion along the first direction is D1, the size of the weak portion along the first direction is D2, and D1 > 2*D2.

5. The case according to claim 3, wherein
the reinforcement support member further comprises a first connecting portion, and the first connecting portion is connected to a side of the reinforcement portion away from the bottom wall of the case body along the first direction; and
the first connecting portion is detachably connected to the cover body.

6. The case according to claim 5, wherein the connecting assembly further comprises a first gasket and a first cover body connector, and the first cover body connector passes through the first gasket, the cover body and the first connecting portion along the first direction, so that the first gasket, the cover body and the first connecting portion are detachably connected.

7. The case according to claim 3, wherein
the weak support member further comprises a second connecting portion, and the second connecting portion is connected to a side of the weak portion away from the bottom wall of the case body along the first direction; and
the second connecting portion is detachably connected to the cover body.

8. The case according to claim 7, wherein the connecting assembly further comprises a second gasket and a second cover body connector, and the second cover body connector passes through the second gasket, the cover body and the second connecting portion along the first direction, so that the second gasket, the cover body and the second connecting portion are detachably connected.

9. The case according to claim 3, wherein
the connecting assembly further comprises an explosion-proof reinforcement member, a reinforcement connector and a reinforcement fastener; and
the reinforcement connector passes through the explosion-proof reinforcement member, the bottom wall of the case body and the reinforcement portion in a listed sequence along the first direction, and an end of the reinforcement connector passing out of the reinforcement portion along the first direction is detachably connected to the reinforcement fastener.

10. The case according to claim 3, wherein
the connecting assembly further comprises a weak connector and a weak fastener; and
the weak connector passes through the bottom wall of the case body and the weak portion in sequence along the first direction, and an end of the weak connector passing out of the weak portion along the first direction is detachably connected to the weak fastener.

11. The case according to claim 3, wherein the weak portion is provided with a groove and/or a notch, so that the gap, which allows the air to flow through, is formed at the weak portion when the pressure inside the case main body reaches the preset threshold.

12. Electrical equipment, comprising the case according to any one of claims 1 to 11.
